# DEMANDE DE BREVET EUROPEEN

(11) **EP 1 705 151 A1**
(43) Date de publication de la demande: **27.09.2006**
(21) Numéro de dépôt: 05292363.8
(22) Date de dépôt: 08.11.2005
(51) Int. Cl.: B81B 3/00, H03H 9/24

(54) **Microsystème électromécanique comprenant une poutre se déformant par flexion**

(30) Priorité: 24.03.2005 FR 0502942
(71) Demandeur: STMICROELECTRONICS SA, 92120 Montrouge (FR); COMMISSARIAT A L'ENERGIE ATOMIQUE, 75015 Paris (FR)
(72) Inventeur: Casset, Fabrice, 38570 Tencin (FR); Segueni, Karim, 28170 Saint Sauveur (FR); De Grave, Arnaud, 38100 Grenoble (FR); Abele, Nicolas, 75006 (FR)
(74) Mandataire: Boire, Philippe Maxime Charles

(57) **Abrégé**

Un microsystème électromécanique comprend une poutre (1) et une électrode (10) couplée par une interaction électrostatique avec la poutre. La poutre est adaptée pour subir des déformations élastiques par flexion et possède un motif de section sensiblement constant. La poutre (1) est constituée de plusieurs pans (P1-P4) s'étendant sur la longueur de la poutre (L), et ayant chacun une épaisseur inférieure à une dimension extérieure du motif de section (w, t). Une fréquence de vibration par flexion de la poutre est alors accrue par rapport à une poutre pleine de mêmes dimensions extérieures. Un tel microsystème est adapté pour des applications à durées de transition très courtes, ou pour réaliser des oscillateurs et des résonateurs à haute fréquence.

## Description

La présente invention concerne un microsystème électromécanique, ou MEMS (pour «Micro-Electro-Mechanical System» en anglais), comprenant une poutre adaptée pour se déformer par flexion. Elle concerne aussi un procédé permettant de réaliser un tel microsystème.

On connaît divers microsystèmes électromécaniques destinés à être intégrés à un dispositif électronique. Par exemple, l'article intitulé « Vibrating RF MEMS for low power wireless communications », de Clark T.-C. Nguyen, Proceedings, 2000 Int. MEMS Workshop (iMEMS'01), Singapore, July 4-6, 2001, pp. 21-34, décrit des microsystèmes de configurations différentes. Parmi ces microsystèmes, certains comprennent une poutre destinée à se déformer élastiquement par flexion, et d'autres comprennent un volume destiné à présenter des variations élastiques dites de contour. Les microsystèmes à variations de contour d'un volume présentent des fréquences de déformation particulièrement élevées, qui sont adaptées à de nombreuses applications. Ils sont cependant difficiles à réaliser et possèdent par conséquent un prix de revient élevé.

Les microsystèmes comprenant une poutre destinée à se déformer par flexion sont plus simples à réaliser et moins onéreux. Mais la fréquence de déformation par flexion de la poutre est trop basse pour certaines applications.

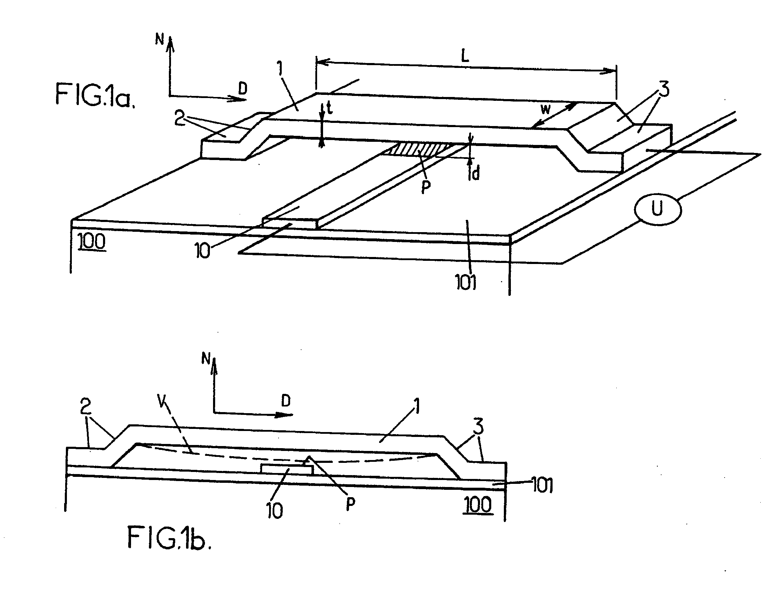

Les figures 1 a et 1b représentent un tel microsystème à poutre de flexion. La figure 1 a est une vue en perspective du microsystème et la figure 1 b est une vue en coupe passant par un plan médian de la poutre. La poutre 1 possède une longueur déterminée L selon une direction longitudinale D, et un motif de section dans un plan perpendiculaire à la direction D sensiblement constant sur au moins une partie principale de la longueur L. Elle est adaptée pour subir des déformations élastiques par flexion.

Dans l'exemple particulier représenté, la poutre 1 présente une épaisseur t inférieure à la largeur w, de sorte que le motif de section est un rectangle allongé. Du fait de la faible épaisseur t, la poutre 1 est adaptée pour se déformer élastiquement par flexion de sorte que des portions élémentaires de la poutre 1 se déplacent en vibrant selon la direction N, parallèle à la direction d'épaisseur t. La poutre 1 peut être reliée mécaniquement à un substrat 100 du microsystème par deux liaisons situées aux extrémités de la poutre, et référencées 2 et 3. La ligne discontinue V sur la figure 1 b illustre une déformation possible d'une ligne longitudinale de la poutre 1 lorsque celle-ci vibre en flexion.

Il est connu qu'une telle poutre peut se déformer en flexion selon des modes différents, caractérisés chacun par un nombre de noeuds de vibration situés dans la longueur de la poutre. Il est aussi connu que la poutre peut posséder différents motifs de section, par exemple en changeant son épaisseur et sa largeur. Enfin, il existe des microsystèmes dans lesquels la poutre se déforme par flexion selon des directions variables, notamment par rapport au substrat 100.

Le microsystème comprend en outre au moins une électrode 10 couplée par interaction électrostatique avec la poutre. Pour cela, la poutre 1 peut être en matériau conducteur, ou posséder un revêtement conducteur, de sorte qu'une partie de la poutre située sensiblement en vis-à-vis avec une partie P de l'électrode 10 forme un condensateur avec celle-ci. Une tension électrique U peut alors être appliquée entre la poutre 1 et l'électrode 10. La tension U engendre une force électrostatique exercée par l'électrode 10 sur la poutre 1, parallèlement à la direction N. La poutre 1 se déforme alors par flexion. De nombreuses configurations de poutre et d'électrode sont utilisées, mais elles correspondent à des vitesses de déformation de la poutre trop faibles pour certaines applications du microsystème.

Un but de la présente invention est donc de proposer un microsystème électromécanique qui soit à la fois simple à réaliser et qui présente des vitesses de déformation supérieures.

Pour cela, l'invention propose un microsystème électromécanique comprenant une poutre de longueur déterminée selon une direction longitudinale et au moins une électrode couplée à la poutre par interaction électrostatique, ladite poutre étant adaptée pour subir des déformations élastiques par flexion et ayant un motif de section dans un plan perpendiculaire à ladite direction longitudinale sensiblement constant sur au moins une partie principale de la longueur de la poutre. La poutre comprend plusieurs pans s'étendant sur une partie principale de sa longueur, qui sont joints entre eux selon des lignes parallèles à la direction longitudinale et qui ont chacun une épaisseur inférieure à au moins une dimension extérieure du motif de section de la poutre. Autrement dit, la poutre du microsystème présente un motif découpé de section, ou est une poutre creuse.

Grâce à un tel motif de section, la poutre peut se déformer par flexion à des vitesses supérieures, si bien que le microsystème peut être utilisé pour des applications qui nécessitent des transitions rapides ou des fréquences d'oscillations élevées. En particulier, le microsystème peut être incorporé à un interrupteur ou à un oscillateur, ou peut être utilisé comme un accéléromètre ou comme un résonateur.

L'épaisseur d'au moins un des pans peut être, par exemple, au moins quatre fois plus petite que la dimension extérieure du motif de section. Une telle poutre possède un poids relativement faible, de sorte que, lorsqu'elle se déforme, elle présente une inertie réduite tout en conservant une raideur élevée. Ses déformations sont alors rapides.

Eventuellement, l'électrode peut être située entre un substrat du microsystème et la poutre. Le microsystème présente alors une configuration particulièrement compacte.

Un avantage d'un microsystème selon l'invention provient du fait que la poutre se déforme par flexion. En effet, étant donné que des déformations de poutre par flexion peuvent avoir une amplitude importante, la poutre et l'électrode peuvent être fabriquées aisément, sans nécessiter une précision élevée pour les dimensions et les emplacements respectifs de la poutre et de l'électrode.

L'invention propose aussi un procédé de fabrication d'un microsystème électromécanique à poutre de flexion du type précédent. Un tel procédé comprend les étapes suivantes :
/a/ former, sur un substrat rigide, une portion en un premier matériau pouvant être gravé sélectivement par rapport à un second matériau ;
/b/ former une poutre en un second matériau, s'étendant au dessus de la portion du premier matériau sur une longueur déterminée selon une direction longitudinale, d'un côté de la portion du premier matériau opposé au substrat ; et
/c/- graver le premier matériau sélectivement par rapport au second matériau de façon à former un premier espace vide entre le substrat et la poutre.

Le procédé comprend en outre une étape de formation d'au moins une électrode sur le substrat, ladite électrode étant agencée pour être couplée à la poutre par interaction électrostatique.

Selon l'invention, l'étape /b/ du procédé comprend la formation de plusieurs pans s'étendant sur au moins une partie principale de la longueur de la poutre et formant, dans un plan perpendiculaire à la direction longitudinale, un motif de section sensiblement constant sur ladite partie principale de la longueur de la poutre, lesdits pans étant joints entre eux selon des lignes parallèles à la direction longitudinale et ayant chacun une épaisseur inférieure à au moins une dimension extérieure du motif de section.

Un tel procédé peut être particulièrement simple à mettre en oeuvre lorsque le motif de section de la poutre est un motif fermé, de forme extérieure carrée ou rectangulaire et formé par quatre pans perpendiculaires deux à deux, ou lorsque le motif de section est de forme en U ou H. En effet, la poutre peut alors être réalisée en combinant des étapes de masquage de parties déterminées du microsystème, des étapes de dépôt de matériaux et des étapes de gravure qui sont simples et bien maîtrisées. De telles étapes peuvent être empruntées, notamment, aux technologies de fabrication de circuits électroniques intégrés. En particulier, la poutre peut avantageusement être à base de silicium ou d'un alliage comprenant du silicium et du germanium. En effet, des procédés de retrait sélectif particulièrement bien maîtrisés existent pour ces matériaux, qui permettent de réaliser avec précision des motifs déterminés.

Le microsystème peut alors être exécuté dans une ligne de fabrication de circuits intégrés. En sélectionnant de façon appropriée les matériaux mis en oeuvre pour réaliser le microsystème, il peut notamment être exécuté dans la partie amont de la ligne de fabrication de circuits intégrés, appelée «front end», en anglais. Dans ce cas, le microsystème peut être réalisé sur un substrat destiné à porter par ailleurs un circuit électronique. Un dispositif particulièrement compact et peu onéreux peut alors être obtenu, qui incorpore à la fois le microsystème électromécanique et le circuit électronique pour exécuter une fonction complexe déterminée. Le microsystème et le circuit électronique peuvent même être fabriqués dans la même ligne de fabrication.

Les pans de la poutre peuvent être réalisés de différentes façons.

Selon une première façon d'opérer, la poutre est directement formée de sorte qu'elle présente initialement plusieurs pans. Elle possède alors, dès sa formation, le motif de section définitif.

Selon une seconde façon d'opérer, une structure allongée peut être d'abord formée, puis gravée de sorte que les pans sont constitués de portions résiduelles de la structure allongée. Le procédé peut comprendre alors en outre une étape /d/ de formation d'un second espace vide entre au moins deux des pans de la poutre. Dans ce cas, les étapes /c/ et /d/ sont réalisées de préférence simultanément, notamment afin de réduire le nombre d'étapes du procédé de fabrication du microsystème.

Selon un mode de mise en oeuvre particulier de cette seconde façon de réaliser la poutre, la poutre peut être formée à l'étape /b/ de sorte que le motif de section entoure au moins partiellement une âme d'un matériau temporaire s'étendant sur la partie principale de la longueur de la poutre. L'étape /d/ comprend alors un retrait sélectif de l'âme de façon à former ledit second espace vide.

Eventuellement, l'électrode peut être formée sur le substrat avant l'étape /a/. Elle peut ainsi être disposée entre le substrat et la poutre, dans l'état final du microsystème.

D'autres particularités et avantages de la présente invention apparaîtront dans la description ci-après d'exemples de réalisation non limitatifs, en référence aux dessins annexés, dans lesquels :
- les figures 1 a et 1b, déjà décrites, représentent un microsystème électromécanique tel que connu de l'art antérieur ;
- les figures 2a-2f illustrent des étapes d'un procédé de fabrication d'un microsystème à poutre de flexion selon l'invention ayant une section carrée évidée ; et
- les figures 3a-3d illustrent des modes alternatifs de réalisation de l'invention.

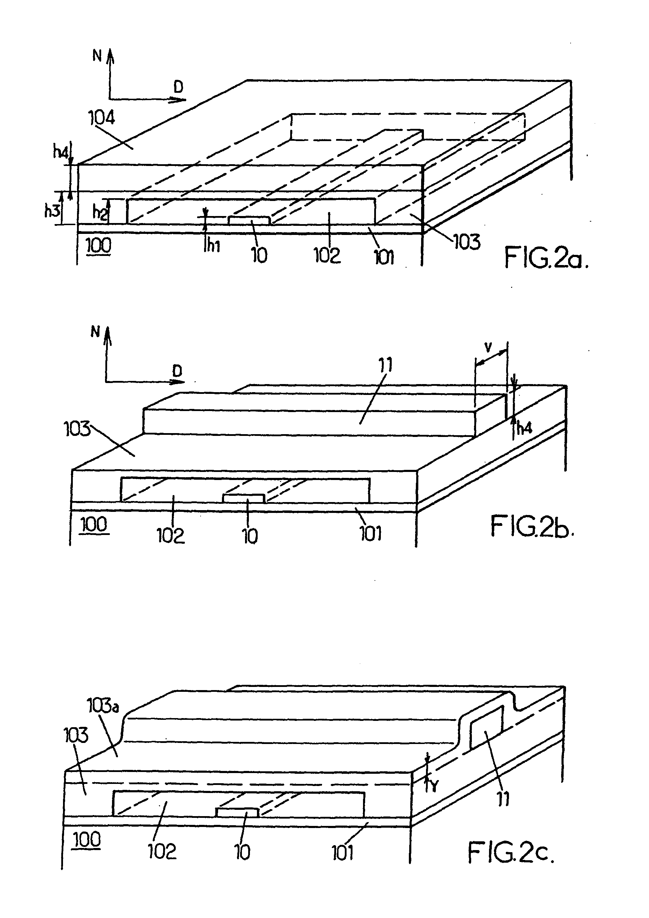

Pour raison de clarté, les dimensions des différents éléments représentés dans ces figures ne sont pas en proportion avec des dimensions réelles. Les figures 1 et 2a-2f sont des vues en perspective d'un substrat sensiblement plan, sur lequel est réalisé un microsystème selon l'invention. Le substrat est placé dans la partie inférieure de chaque figure, et N désigne une direction perpendiculaire à la surface du substrat, orientée vers le haut des figures. Dans la suite, les termes «sur», «sous», «inférieur» et «supérieur» sont utilisés en référence à cette orientation. Par ailleurs, sur toutes les figures, des références identiques correspondent à des éléments identiques.

On décrit maintenant un procédé de fabrication d'un microsystème selon l'invention, en référence aux figures 2a-2f. Dans cette description, des étapes élémentaires du procédé qui sont connues de la fabrication d'un circuit électronique intégré ne sont pas reprises en détail. On s'attache seulement à décrire une succession d'étapes élémentaires qui permet de réaliser le microsystème.

Conformément à la figure 2a, un substrat comprend une base de substrat 100, par exemple en silicium monocristallin (Si), recouverte d'une couche 101 de silice (SiO₂). La couche 101 est isolante électriquement. Une bande 10 est disposée sur la couche 101, dans une partie centrale de celle-ci. La bande 10 peut être en alliage de silicium et de germanium (Si-Ge), conducteur électriquement. La bande 10 est recouverte par un volume 102 de silicium, dont la surface supérieure est rendue plane par polissage CMP (pour «Chemical-Mechanical Polishing» en anglais). Le volume 102 est lui-même recouvert par un volume 103 d'alliage de silicium et de germanium, dont la surface supérieure est aussi aplanie. Enfin, le volume 103 est recouvert d'une couche 104 de silicium. Une telle structure est facilement élaborée par un spécialiste de la conception et de la fabrication de circuits intégrés, en combinant des étapes de dépôts par épitaxie de silicium ou d'alliage de silicium et de germanium, de masquage et de gravure. En particulier, la base de substrat 100, la couche 101 et une partie au moins du volume 102 peuvent être obtenus à partir d'un substrat utilisé en technologie SOI (pour «Silicon On Isolator» en anglais) de fabrication des circuits électroniques intégrés, et disponible commercialement. Les matériaux de la bande 10, des volumes 102 et 103, ainsi que de la couche 104 sont alors sensiblement monocristallins.

Les épaisseurs respectives de la bande 10, du volume 102, du volume 103 et de la couche 104, selon la direction N, sont notées h₁, h₂, h₃ et h₄. h₁ est inférieure à h₂, elle-même inférieure à h₃. A titre d'exemple, les valeurs approximatives suivantes peuvent être adoptées : h₁ est égale à 0,02 µm (micromètres), h₂ est égale à 1,0 µm, h₃ est égale à 1,1 µm et h₄ est égale à 0,8 µm. Selon la direction D, la bande 10, le volume 102 et le volume 103 possèdent des largeurs respectives croissantes dans cet ordre.

La couche 104 est ensuite recouverte d'un masque (non représenté) en forme de bande parallèle à la direction D, de largeur v égale 0,8 µm environ. La couche 104 est alors gravée en dehors du masque, par exemple en utilisant un procédé de gravure sélective du silicium par rapport à l'alliage de silicium et de germanium. Un tel procédé de gravure sélective est bien connu de l'Homme du métier, et n'est pas repris ici. Cette gravure est désignée dans la suite par première étape de gravure. Une bande en silicium 11, parallèle à la direction D, de largeur v et d'épaisseur h₄, est ainsi formée sur le volume 103 (figure 2b). Le masque est ensuite retiré.

On effectue alors un dépôt d'alliage de silicium et de germanium sur le volume 103 et la bande 11, par croissance épitaxiale. Une couche 103a d'alliage est ainsi formée, qui est conforme par rapport au relief de la bande 11 au dessus du volume 103. Le dépôt de la couche 103a est poursuivi jusqu'à ce que la couche 103a présente une épaisseur y de 0,1 µm environ (figure 2c).

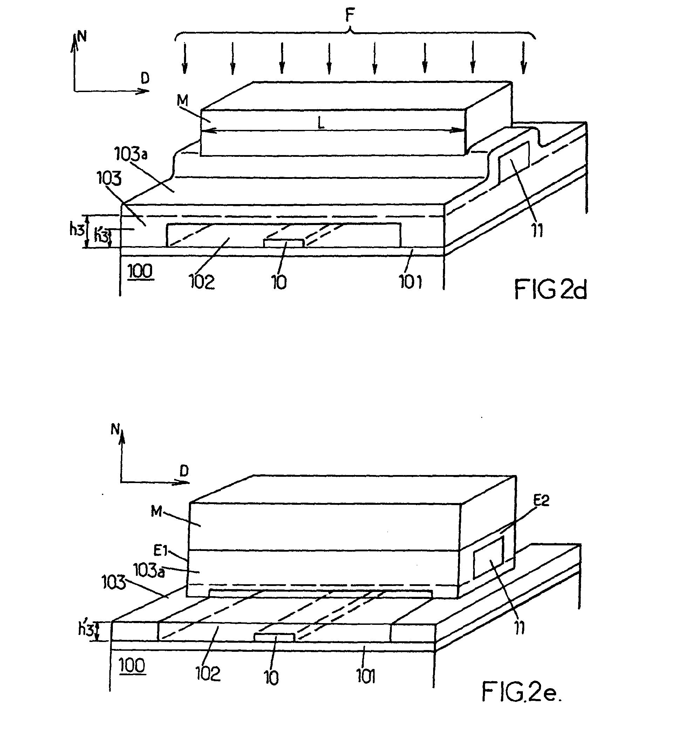

Un second masque, référencé M sur la figure 2d, est formé sur la couche 103a, à l'aplomb de la bande 11. Le masque M possède une largeur supérieure à v, par exemple égale à 1,0 µm, selon la direction parallèle à la surface de la base 100 et perpendiculaire à la direction D. En outre, le masque M possède une longueur L selon la direction D intermédiaire entre les largeurs respectives des volumes 102 et 103. Le masque M est positionné sur la couche 103a de façon centrée par rapport à la bande 11 et au volume 102, dans un plan parallèle à la surface de la base 100.

Une deuxième étape de gravure est alors effectuée, en utilisant un flux F de particules accélérées selon la direction N, en sens inverse de celle-ci. Le flux F est dirigé contre la surface supérieure de la couche 103a (figure 2d). Cette deuxième gravure est poursuivie jusqu'à retirer entièrement les parties découvertes de la couche 103a. Eventuellement, la deuxième étape de gravure peut être poursuivie de façon à éliminer en outre des parties supérieures respectives des volumes 103 puis 102 (figure 2e). Les volumes 102 et 103 présentent alors des épaisseurs respectives sensiblement égales selon la direction N, notées h₃' sur les figures 2d et 2e. Par exemple, h₃' est égale à 0,8 µm environ. Simultanément, la gravure directionnelle forme deux faces d'extrémités E1 et E2, situées de part et d'autre de la bande 11 selon la direction D.

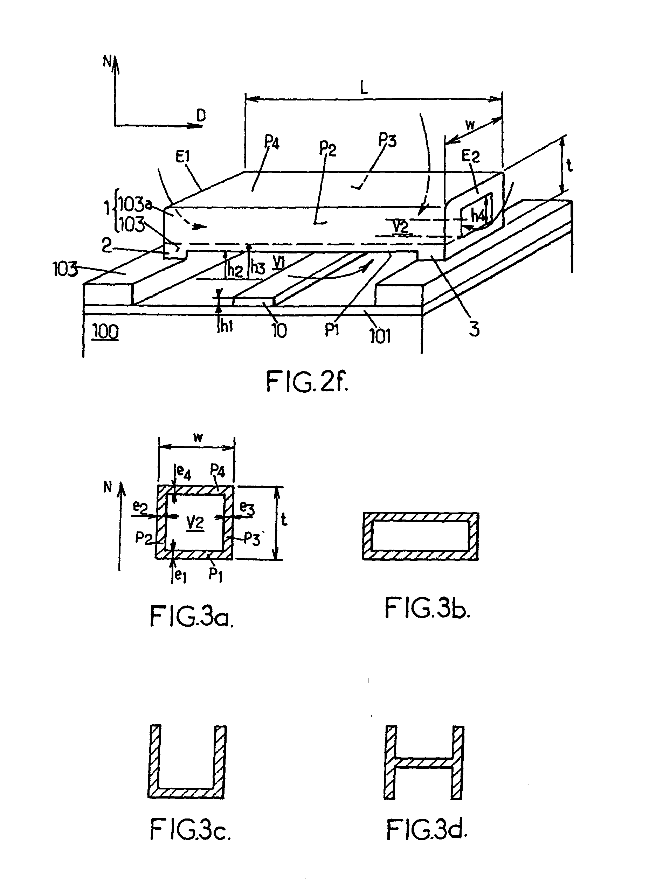

Le masque M est retiré et une troisième étape gravure, de type isotrope, est mise en oeuvre pour éliminer sélectivement les parties de silicium sensiblement dépourvu de germanium restant au dessus de la couche de silice 101. Un fluide de gravure sélective peut être utilisé pour cette troisième étape de gravure, qui est identique à celui mis en oeuvre lors de la première étape de gravure. La partie résiduelle du volume 102 est ainsi retirée, par les faces du volume 102 découvertes lors de la gravure directionnelle par le flux F. Un premier espace vide V1 est ainsi formé entre la couche 101 et la partie supérieure résiduelle de la couche 103 (figure 2f). L'espace vide V1 présente une épaisseur h₂-h₁ entre la poutre 1 et la bande 10 selon la direction N.

Une structure en pont est ainsi obtenue, qui est reliée à la couche 101 par deux liaisons mécaniques 2, 3 situées à des extrémités de la structure opposées selon la direction D. Les liaisons 2, 3 sont constituées par des parties latérales résiduelles du volume 103. La structure en pont est en alliage de silicium et de germanium, conducteur électriquement. Elle possède une forme de poutre disposée horizontalement au dessus de la bande 10, tout en étant isolée électriquement de celle-ci. Cette poutre est référencée 1 sur la figure 2f. La poutre 1 présente une longueur selon la direction D égale à celle du masque M, c'est-à-dire égale à L. L peut être égale à 10 µm, par exemple. D est alors la direction longitudinale de la poutre 1.

La bande de silicium 11 est retirée en même temps que la partie résiduelle du volume 102 lors de cette troisième gravure. Elle est retirée par les faces d'extrémités E1 et E2, de sorte qu'un second espace vide V2 est formé entre les parties résiduelles des couches 103 et 103a. Sur la figure 2f, des flèches courbes représentent les directions d'accès du fluide de gravure aux parties en silicium dépourvues de germanium, destinées à être éliminées.

La poutre 1 devient ainsi creuse : l'espace vide V2 est situé au coeur de la poutre 1, à la place de la bande 11. Pour cette raison, la bande 11 est appelée âme de la poutre 1, constituée de matériau temporaire puis éliminée.

La poutre 1 présente une section de largeur extérieure w=v+2y= 1,0 µm (figure 3a). Les quatre côtés de cette section sont formés par les pans P1, P2, P3 et P4, orthogonaux deux à deux et reliés par leurs arrêtes parallèles à la direction D. Le pan P1 est formé par une partie supérieure du volume 103, d'épaisseur e₁=h₃-h₂ égale à 0,1 µm dans l'exemple décrit ici. Les pans P2, P3 et P4 correspondent à des parties résiduelles de la couche 103a, qui ont été protégées par le masque M lors de la seconde étape de gravure. Ils ont chacun une épaisseur sensiblement égale à y, c'est-à-dire de 0,1 µm environ et notée e₂, e₃ et e₄ sur la figure 3a. Les épaisseurs e₁-e₄ sont inférieures à la largeur extérieure w.

L'épaisseur extérieure de la poutre 1 selon la direction N, notée t, est sensiblement égale la somme de h₄, de y et de h₃-h₂. Elle est égale à 1,0 µm environ. Les épaisseurs e₁-e₄ sont donc aussi inférieures à t. La poutre 1 présente donc un motif de section carré (figure 3a).

De nombreuses adaptations peuvent être introduites dans le procédé de fabrication d'une poutre qui vient d'être décrit. Parmi ces adaptations, on peut citer les suivantes :
- les dimensions de la poutre, i.e. sa longueur L, sa largeur intérieure v et sa hauteur intérieure h₄, sa largeur extérieure w et son épaisseur extérieure t, peuvent être variées ;
- la poutre peut posséder un motif de section de forme rectangulaire (figure 3b), en U (figure 3c) ou en H (figure 3d), avec des orientations variables par rapport à la direction N ;
- la poutre peut être en silicium. Dans ce cas, les portions de couches et de volumes qui sont gravées sélectivement lors du procédé de fabrication du microsystème peuvent être en alliage de silicium et de germanium. Des étapes de gravure sélective de l'alliage par rapport à des portions de silicium dépourvues de germanium sont aussi connues de l'Homme du métier et peuvent être mises en oeuvre d'une façon équivalente à celle qui a été décrite en détail ;
- la poutre peut être en matériau isolant électriquement, et recouverte au moins en partie d'une couche de matériau électriquement conducteur ;
- enfin, les appuis 2 et 3 peuvent être situés en des endroits de la longueur de la poutre 1 autres que les extrémités de celle-ci selon la direction D. En particulier, la poutre peut être reliée mécaniquement au substrat 100 par au moins une liaison située à un endroit dans la longueur de la poutre qui correspond à un noeud d'un mode propre de vibration par flexion de la poutre.

Le tableau ci-dessous compare des valeurs de fréquences de vibration par flexion d'une poutre résultant du procédé de fabrication qui a été décrit en détail ci-dessus. Ces valeurs sont données pour les cinq premiers modes propres de vibration de la poutre, et sont comparées à celles d'une poutre de même longueur (10 µm) et de section carrée pleine de 1,0 µm de côté. Elles sont exprimées en mégahertz (MHz).

| Modes propres de vibration par flexion | Poutre selon l'invention | Poutre pleine |
|---|---|---|
| 1 | 82,884 | 74,326 |
| 2 | 87,386 | 77,178 |
| 3 | 90,874 | 191,909 |
| 4 | 108,058 | 198,449 |
| 5 | 113,131 | 235,533 |

II apparaît que l'invention permet d'augmenter la fréquence de vibration par flexion d'une poutre d'environ 12% pour le premier mode propre, par rapport à une poutre pleine ayant des dimensions extérieures identiques. De même, la fréquence de vibration par flexion du second mode propre est augmentée de 9% environ. Pour les modes propres suivants, l'invention aboutit à une diminution de la fréquence de vibration, ce qui peut permettre d'ajuster la fréquence de vibration en fonction de l'application du microsystème.

A titre d'exemple complémentaire de réalisation de l'invention, les inventeurs ont fabriqué une seconde poutre creuse, de longueur 500 µm, avec un motif de section carré de dimensions extérieures 60 µm x 60 µm, et constituée de quatre pans chacun d'épaisseur 10 µm. Le premier mode de vibration par flexion d'une telle poutre présente une fréquence de 2,1 MHz. Pour comparaison, une poutre pleine de même longueur et de mêmes dimensions extérieures présente une fréquence de premier mode de vibration par flexion comprise entre 1,80 et 1,85 MHz.

Enfin, une troisième poutre creuse a été réalisée, de longueur 50 µm avec un motif de section carré de dimensions extérieures 8 µm x 8 µm. Cette troisième poutre est constituée de quatre pans d'épaisseur 1,4 µm chacun. Elle présente une fréquence de premier mode de vibration par flexion de 24,5 MHz, alors qu'une poutre pleine de mêmes dimensions extérieures présente une fréquence correspondante de 23 MHz environ.

La bande 10 constitue l'électrode du microsystème électromécanique. Elle est couplée par interaction électrostatique avec la poutre 1. Autrement dit, un champ électrique est présent dans l'espace de séparation situé entre la poutre 1 et la bande 10 lorsqu'une tension électrique est appliquée entre la poutre 1 et la bande 10. Ce champ électrique exerce une force sur la poutre 1, parallèlement à la direction N. Alternativement, l'électrode peut comprendre une grille d'un transistor MOS.

Eventuellement, le microsystème peut comprendre en outre une seconde électrode couplée par interaction électrostatique avec la poutre 1. Une telle seconde électrode peut être nécessaire pour certains dispositifs incorporant un microsystème à poutre de flexion selon l'invention. Dans ce cas, les deux électrodes peuvent être respectivement une électrode d'excitation et une électrode de détection des vibrations de la poutre 1. Lorsque l'électrode de détection est constituée par la grille d'un transistor MOS, un signal électrique causé par une vibration de la poutre est détecté, et est directement amplifié sous forme d'un courant principal circulant entre la source et le drain du transistor. Ce courant principal est modulé par les variations du potentiel électrique de la grille qui sont provoquées par le fléchissement de la poutre 1.

Un microsystème à poutre de flexion tel que décrit précédemment peut être incorporé à divers dispositifs électromécaniques. Lorsque le dispositif est un micro-interrupteur, la déformation rapide de la poutre permet d'obtenir des ouvertures de circuit électrique particulièrement rapides. Lorsque le dispositif est un accéléromètre, celui-ci est adapté pour mesurer des accélérations supérieures, qui provoqueraient une saturation, ou éventuellement une rupture, des accéléromètres à poutre de flexion ayant une forme lame mince flexible.

Lorsque le dispositif qui incorpore un microsystème selon l'invention est un oscillateur ou un résonateur, la fréquence d'oscillation propre ou les premières fréquences de résonance de celui-ci sont particulièrement élevées et adaptées à un grand nombre d'applications. En outre, le facteur de qualité d'un tel résonateur peut être particulièrement bon, lorsque la poutre est constituée de matériau cristallin, voire monocristallin. Ce peut être le cas, notamment, lorsque la poutre est constituée de silicium et est dépourvue de germanium, car elle peut alors présenter une quantité de défauts cristallins particulièrement réduite.

Enfin, le microsystème électromécanique qui a été décrit en détail est adapté pour être réalisé dans la partie amont («front end») d'une ligne de fabrication de circuits intégrés. Un microsystème électromécanique selon l'invention peut aussi être réalisé dans la partie aval d'une ligne de fabrication de circuits intégrés, désignée par «back end» en anglais. Dans ce cas, la poutre 1 peut être en matériau de type nitrure, l'électrode 10 peut être en or et le volume 102 peut être en résine ou en polymère. Etant donné que la poutre 1 est alors isolante électriquement, elle doit être équipée d'une contre-électrode, qui peut aussi être en or. Cette contre-électrode est disposée sur la poutre 1 en vis-à-vis de l'électrode 10, de façon à interagir avec cette dernière. En outre, un microsystème réalisé dans la partie aval de la ligne de fabrication peut être disposé au dessus d'un circuit intégré réalisé sur le substrat, de sorte que le niveau d'intégration qui est obtenu pour l'ensemble du circuit et du microsystème est supérieur. Une telle disposition est appelée «integration above IC» (IC pour «Integrated Circuit»).

## Revendications

1. Microsystème électromécanique comprenant une poutre (1) de longueur déterminée (L) selon une direction longitudinale (D) et au moins une électrode fixe (10) couplée à la poutre par interaction électrostatique, ladite poutre étant adaptée pour subir des déformations élastiques par flexion et ayant un motif de section dans un plan perpendiculaire à ladite direction longitudinale sensiblement constant sur au moins une partie principale de la longueur de la poutre,
**caractérisé en ce que** la poutre (1) comprend plusieurs pans (P1-P4) s'étendant sur la partie principale de la longueur de la poutre, lesdits pans étant joints entre eux selon des lignes parallèles à la direction longitudinale (D) et ayant chacun une épaisseur (e₁-e₄) inférieure à au moins une dimension extérieure du motif de section (w, t).

2. Microsystème selon la revendication 1, dans lequel l'épaisseur d'au moins un des pans de la poutre (e₁-e₄) est au moins quatre fois plus petite que ladite dimension extérieure du motif de section (w, t).

3. Microsystème selon la revendication 1 ou 2, dans lequel le motif de section est un motif fermé, de forme extérieure carrée ou rectangulaire et formé par quatre pans (P1-P4) perpendiculaires deux à deux.

4. Microsystème selon la revendication 1 ou 2, dans lequel le motif de section est de forme en U ou H.

5. Microsystème selon l'une quelconque des revendications 1 à 4, dans lequel la poutre (1) est essentiellement à base de silicium ou d'un alliage comprenant du silicium et du germanium.

6. Microsystème selon l'une quelconque des revendications 1 à 5, dans lequel la poutre (1) est reliée mécaniquement à un substrat (100) portant l'électrode (10) par au moins une liaison (2, 3) située à une extrémité de la poutre ou à un endroit dans la longueur de la poutre correspondant à un noeud d'un mode propre de vibration par flexion de la poutre.

7. Microsystème selon l'une quelconque des revendications 1 à 6, dans lequel l'électrode (10) comprend une grille d'un transistor MOS.

8. Microsystème selon l'une quelconque des revendications 1 à 7, comprenant une électrode d'excitation et une électrode de détection, couplées chacune par une interaction électrostatique avec la poutre (1).

9. Interrupteur comprenant un microsystème électromécanique selon l'une quelconque des revendications 1 à 6.

10. Accéléromètre comprenant un microsystème électromécanique selon l'une quelconque des revendications 1 à 7.

11. Oscillateur comprenant un microsystème électromécanique selon l'une quelconque des revendications 1 à 8.

12. Résonateur comprenant un microsystème électromécanique selon l'une quelconque des revendications 1 à 8.

13. Procédé de fabrication d'un microsystème électromécanique comprenant les étapes suivantes :
/a/ former, sur un substrat rigide (100), une portion (102) en un premier matériau pouvant être gravé sélectivement par rapport à un second matériau ;
/b/ former une poutre (1) en second matériau, s'étendant au dessus de la portion du premier matériau (102) sur une longueur déterminée (L) selon une direction longitudinale (D), d'un côté de la portion du premier matériau opposé au substrat (100) ; et
/c/- graver le premier matériau (102) sélectivement par rapport au second matériau de façon à former un premier espace vide (V1) entre le substrat (100) et la poutre (1),
et comprenant en outre une étape de formation d'au moins une électrode (10) sur le substrat (100), ladite électrode étant agencée pour être couplée à la poutre (1) par interaction électrostatique,
le procédé étant **caractérisé en ce que** l'étape /b/ comprend la formation de plusieurs pans (P1-P4) s'étendant sur au moins une partie principale de la longueur de la poutre (L) et formant, dans un plan perpendiculaire à ladite direction longitudinale (D), un motif de section sensiblement constant sur ladite partie principale de la longueur de la poutre, lesdits pans (P1-P4) étant joints entre eux selon des lignes parallèles à la direction longitudinale (D) et ayant chacun une épaisseur inférieure (e₁-e₄) à au moins une dimension extérieure du motif de section (w, t).

14. Procédé selon la revendication 13, comprenant en outre une étape /d/ de formation d'un second espace vide (V2) entre au moins deux des pans de la poutre (P1-P4).

15. Procédé selon la revendication 14, suivant lequel la poutre (1) est formée à l'étape /b/ de sorte que le motif de section entoure au moins partiellement une âme (11) d'un matériau temporaire s'étendant sur la partie principale de la longueur de la poutre (L), et suivant lequel l'étape /d/ comprend un retrait sélectif de ladite âme de façon à former ledit second espace vide (V2).

16. Procédé selon la revendication 14 ou 15, selon lequel les étapes /c/ et /d/ sont réalisées simultanément.
